# EUROPEAN PATENT APPLICATION

(11) **EP 1 777 274 A1**
(43) Date of publication of application: **25.04.2007**
(21) Application number: 05758269.4
(22) Date of filing: 05.07.2005
(51) Int. Cl.: C09D 17/00, C09B 67/08, C09B 67/46, C09C 3/10, G02B 5/20, G03F 7/004

(54) **PIGMENT DISPERSION COMPOSITION, USE THEREOF AND COMPOUND FOR TREATING PIGMENT**

(30) Priority: 06.07.2004 JP 2004199754
(71) Applicant: SAKATA INX CORPORATION, Osaka-shi, Osaka 550-0002 (JP)
(72) Inventor: ITO, Kazunori, c/o SAKATA INX CORP., Osaka-shi, Osaka 5500002 (JP); SHIBATA, Hideo, c/o SAKATA INX CORP., Osaka-shi, Osaka 5500002 (JP); KITAOKA, Naoyuki, c/o SAKATA INX CORP., Osaka-shi, Osaka 5500002 (JP); HAYASHI, Akira, c/o SAKATA INX CORP., Osaka-shi, Osaka 5500002 (JP); KITA, Tomohiro, c/o SAKATA INX CORP., Osaka-shi, Osaka 5500002 (JP)
(74) Representative: Hart Davis, Jason
(86) International application number: PCT/JP2005/012382
(87) International publication number: WO 2006/011338

(57) **Abstract**

The present invention provides a pigment dispersion composition which has good fluidity and dispersion stability even in the case of having a high pigment concentration and exhibits excellent development characteristics when it is used for the areas requiring development characteristics such as a resist composition for a color filter or a resist composition for a black matrix.
The pigment dispersion composition of the present invention is a pigment dispersion composition formed by dispersing a pigment in a dispersion medium,
wherein the surface of said pigment is coated with an acid radical-containing reactant produced by the reaction of a carbodiimide compound having at least one carbodiimide group with an acid radical-containing resin having an acid value of 20 to 300 mgKOH/g and a weight average molecular weight of 1000 to 100000.

## Description

### TECHNICAL FIELD

The present invention relates to a pigment dispersion composition and applications thereof and more particularly to a pigment dispersion composition which is used as a pigment-containing base composition in the area of various coloring matter and has good fluidity and dispersion stability even in the case of having a high pigment concentration and in a state of dispersing a pigment finely. The present invention further relates to a pigment dispersion resist composition which can attain a black matrix and a color filter having excellent development characteristics. Further, the present invention relates to a compound for pigment treatment suitable for treating a pigment.

### BACKGROUND ART

Recently, also in the areas of resist compositions for a color filter and ink for ink jet as well as a printing ink and a coating material, where a vivid hue is required, a pigment begins being utilized as a coloring matter. Further, in these areas of a color filter or ink jet recording, it is studied to use a high-grade pigment for the requirements of high toughness and to employ a method of achieving finer particle diameter in order to attain a more vivid hue. However, the high-grade pigment is inherently low in the dispersion stability compared with other pigments and it further becomes apt to coagulate and hard to achieve stable dispersed matter as the particles becomes finer.

On the other hand, the applications of the black matrix of the color filter are being shifted from a metal thin film of chromium or the like to a coating film and carbon black is widely used as a light shield material, but since it has a fine primary particle diameter and also has properties that it is porous and specific surface area is large, there is a problem that an increase in the concentration of a pigment is difficult and dispersion stability is low.

Further, in order to meet the recently particularly growing market demands for thinning a film of color filters and black matrixes, an increase in the concentration of a pigment component is essential, but this increase in the concentration results in further encouraging the reduction in dispersion stability and fluidity. Accordingly, in order to retain excellent dispersion stability and fluidity of the pigment particularly in the pigment dispersion composition increased in the concentration, the present inventors have proposed a pigment dispersant based on a method of using a compound having a carbodiimide group as a method of utilizing a functional group and a covalent bond existing at the surface of the pigment (see, for example, Patent Document 1), a method of using a carbodiimide compound as a starting material and utilizing an acid-base affinity as a method of utilizing an adsorption force with the surface of the pigment (see, for example, Patent Document 2), and a method of utilizing an affinity resulting from the similarity of a molecular structure (see, for example, Patent Document 3).

Such the pigment dispersant proposed by the present inventors have very good dispersion stability and fluidity even in the case of having a high pigment concentration and is suitably used in a resist composition for a color filter or a resist composition for a black matrix. Further, in an organic pigment, a film of vivid contrast is formed and in black pigment such as carbon black, a film having high insulating or light shielding properties is formed and further development characteristics of the resist composition is improved, and the present invention can attain excellent effects.

However, since today's competitions from various electronic image display devices such as a plasma display type and an organic EL type become sever, it becomes indispensable to improve vividness and sharpness of a color liquid crystal display more. First, in order to reduce a smear of color impairing vividness and sharpness as far as possible, it becomes a very large issue to eliminate the defects of patterns of the color filter and the black matrix, causing the smear of color.

The color filter and the black matrix are obtained by a method in which generally, a photosensitive resist film is applied onto a substrate and exposed with ultraviolet light through a mask having a desired pattern to cure the coat and a unexposed coat is removed by a developer to form a pattern. Further, in order to form this pattern, a resist composition formed by adding a photosensitive material to the pigment dispersion composition described above is used. In forming the pattern, it is required for attaining a good pattern that the resist composition has good development characteristics, for example, adequate reproducibility of the fine line by exposing/developing, and patterns with a sharp edge can be formed, the time (development margin) that elapsed before an exposed portion is eliminated after the removal of a unexposed portion by a developer is long, and further there is no development residue in the unexposed portion.

However, since it is currently already difficult to attain good suitability for development, there is a further difficult problem in the resist composition having a high pigment concentration required for thinning a film. For example, there is a problem that when the concentration of the pigment becomes high, ultraviolet light does not reach the inside and the coat remains uncured around the substrate, and therefore a development margin is reduced and an edge portion becomes reversely tapered to deteriorate sharpness. Further, there is a problem that the coat tends to be removed in a coagulated state in developing and residue tends to be produced.

In order to solve the problems in the suitability for development like this, it has been tried to improve the suitability for development by containing a material which is easy to be removed by an alkaline developer as represented by a method of making use of an anionic surfactant described (see, for example, Patent Document 4) and a method of making use of an alkali-soluble resin described (see, for example, Patent Document 5). But, in the resist composition of the high pigment concentration, even if the above-mentioned materials are used as-is, the development margin remains low and therefore the problem that the film tends to be removed in a coagulated state in developing remains and the problem that residue tends to be produced could not be improved.

Patent Document 1: International Publication WO 03/076527
Patent Document 2: International Publication WO 04/000950
Patent Document 3: International Publication WO 04/003085
Patent Document 4: Japanese Kokai Publication Hei08-220743
Patent Document 5: Japanese Kokai Publication Hei08-220760

### DISCLOSURE OF THE INVENTION

### Problem to be Solved by the Invention

It is an object of the present invention to provide a pigment dispersion composition which has good fluidity and dispersion stability even in the case of having a high pigment concentration and exhibits excellent development characteristics when it is used for the areas requiring development characteristics such as a resist composition for a color filter or a resist composition for a black matrix.
Further, it is an object of the present invention to provide pigment dispersion resist compositions for a black matrix and for a color filter having excellent fluidity, dispersion stability and development characteristics. Also, it is an object of the present invention to provide a compound for pigment treatment suitable for treating a pigment.

### Means for Solving the Problem

The present inventors made various investigations, and consequently they found that the above-mentioned problems can be solved by employing a pigment dispersion composition in which a pigment obtained by coating the surface of the pigment with an acid radical-containing reactant produced by the reaction of a carbodiimide compound having at least one carbodiimide group with an acid radical-containing resin having an acid value of 20 to 300 mgKOH/g and a weight average molecular weight of 1000 to 100000 is dispersed in a dispersion medium of the pigment dispersion composition. These findings have now led to completion of the present invention.
That is, the present invention pertains to (1) a pigment dispersion composition formed by dispersing a pigment in a dispersion medium, wherein the surface of the above-mentioned pigment is coated with an acid radical-containing reactant produced by the reaction of a carbodiimide compound having at least one carbodiimide group with an acid radical-containing resin having an acid value of 20 to 300 mgKOH/g and a weight average molecular weight of 1000 to 100000.
Further, the present invention pertains to (2) the pigment dispersion composition according to the above paragraph (1), wherein the above-mentioned carbodiimide compound has at least one kind of a side chain selected from the group consisting of a polyester side chain, a polyether side chain and a polyacrylic side chain in a molecule.
Further, the present invention pertains to (3) the pigment dispersion composition according to the above paragraph (1) or (2), wherein above-mentioned carbodiimide compound is a carbodiimide compound with a carbodiimide equivalent of 100 to 50000.
Further, the present invention pertains to (4) the pigment dispersion composition according to any one of the above paragraphs (1) to (3), wherein an acid radical of the above-mentioned acid radical-containing resin is a carboxyl group, a sulfonic acid group or a phosphoric acid group.
Further, the present invention pertains to (5) the pigment dispersion composition according to any one of the above paragraphs (1) to (4), wherein the above-mentioned acid radical-containing resin is an acid radical-containing copolymer resin obtained by radically polymerizing a monomer component containing at least one kind of monomers having an acid radical.

Further, the present invention pertains to (6) a method of producing the pigment dispersion composition according to any one of the above paragraphs (1) to (5), comprising the steps of: coating the surface of a pigment using an acid radical-containing reactant obtained by reacting a carbodiimide compound having at least one carbodiimide group with an acid radical-containing resin having an acid value of 20 to 300 mgKOH/g and a weight average molecular weight of 1000 to 100000 in advance; and dispersing the coated pigment in a dispersion medium.
Further, the present invention pertains to (7) a method of producing the pigment dispersion composition according to any one of the above paragraphs (1) to (5), comprising the steps of: coating the surface of a pigment by pre-treating the surface of a pigment with a carbodiimide compound having at least one carbodiimide group and then reacting a residual carbodiimide group in the carbodiimide compound with an acid radical-containing resin having an acid value of 20 to 300 mgKOH/g and a weight average molecular weight of 1000 to 100000; and dispersing the coated pigment in a dispersion medium.
Further, the present invention pertains to (8) a method of producing the pigment dispersion composition according to any one of the above paragraphs (1) to (5), comprising the steps of: coating the surface of a pigment by conducting a reaction in a mixture containing at least a pigment, a carbodiimide compound having at least one carbodiimide group, and an acid radical-containing resin having an acid value of 20 to 300 mgKOH/g and a weight average molecular weight of 1000 to 100000; and dispersing the coated pigment in a dispersion medium.
Further, the present invention pertains to (9) the method of producing the pigment dispersion composition according to any one of the above paragraphs (6) to (8), wherein the step of coating the surface of a pigment and the step of dispersing the pigment in a dispersion medium are simultaneously performed.
Further, the present invention pertains to (10) a pigment dispersion resist composition containing the pigment dispersion composition according to any one of the above paragraphs (1) to (5).
Further, the present invention pertains to (11) a compound for pigment treatment, wherein the above-mentioned compound for pigment treatment is obtained by reacting a carbodiimide compound having at least one carbodiimide group with an acid radical-containing resin having an acid value of 20 to 300 mgKOH/g and a weight average molecular weight of 1000 to 100000 and further has an acid radical in a molecule.

Hereinafter, the present invention will be described in detail.
The pigment dispersion composition of the present invention is a pigment dispersion composition formed by dispersing a pigment in a dispersion medium, wherein the surface of the above-mentioned pigment is coated with an acid radical-containing reactant produced by the reaction of a carbodiimide compound having at least one carbodiimide group with an acid radical-containing resin having an acid value of 20 to 300 mgKOH/g and a weight average molecular weight of 1000 to 100000.
Incidentally, in the pigment dispersion composition of the present invention, the expression that "the surface of the pigment is coated with an acid radical-containing reactant produced by the reaction of a carbodiimide compound having at least one carbodiimide group with an acid radical-containing resin having an acid value of 20 to 300 mgKOH/g and a weight average molecular weight of 1000 to 100000" refers to a state in which the above acid radical-containing reactant covalently bonds to or adsorbs on the surface of the pigment. In the present invention, examples of the above-mentioned adsorption include the adsorption by an acid-base affinity and the adsorption by an affinity resulting from the similarity of a molecular structure.

When the acid radical-containing reactant coats the surface of the pigment through a covalent bond, it is preferred that the carbodiimide group of the carbodiimide compound reacts with a functional group existing at the surface of the pigment to form a covalent bond and further a carbodiimide group of the carbodiimide compound, not having used in this covalent bond, is bonded to an acid radical of the acid radical-containing resin.
Further, when the acid radical-containing reactant coats the surface of the pigment through adsorption, all of the carbodiimide groups of the carbodiimide compound bond to the acid radical of the acid radical-containing resin and the acid radical-containing reactant adsorbs on the surface of the pigment through the use of an acid-base affinity and the adsorption by an affinity resulting from the similarity of a molecular structure.
In the present invention, a pigment coated through a covalent bond and a pigment coated through adsorption may be present together as the above-mentioned pigment.
Further, in the pigment dispersion composition of the present invention, any of the reaction of the above-mentioned carbodiimide compound with the above-mentioned acid radical-containing resin and the covalent bond to or the adsorption on the surface of the pigment may be performed first as long as the surface of the pigment is coated with the above acid radical-containing reactant ultimately in the obtained pigment dispersion composition.

The above-mentioned acid radical-containing reactant coating the surface of the pigment is obtained by the reaction of the carbodiimide group which the carbodiimide compound has with the acid radical of the acid radical-containing resin, but it has an unreacted acid radical in a molecule. The pigment dispersion composition of the present invention has an acid radical at the surface of the pigment because the acid radical-containing reactant having the unreacted acid radical in a molecule coats the surface of the pigment, and this pigment dispersion substance exhibits excellent development characteristics when it is used for the areas requiring development characteristics such as a resist composition for a color filter or a resist composition for a black matrix.
In addition, the fact that the acid radical-containing reactant and the pigment coated with the acid radical-containing reactant have unreacted acid radical can be confirmed based on the presence or absence of the peaks of infrared rays with a wavelength of 1700 cm⁻¹.
In the above-mentioned acid radical-containing reactant, it is preferred that all of the carbodiimide group originated from the carbodiimide compound disappear by reacting with a functional group at the surface of the pigment or reacting with the acid radical of the acid radical-containing resin. If an unreacted carbodiimide group remains in the above acid radical-containing reactant, the unreacted carbodiimide group reacts with the functional group at the surface of the pigment and/or the acid radical of the acid radical-containing reactant, which tends to deteriorate the fluidity and the dispersion stability of the pigment dispersion composition.

Hereinafter, materials composing the pigment dispersion composition of the present invention will be described.
The carbodiimide compound composing the pigment dispersion composition of the present invention has at least one carbodiimide group, namely, a group expressed by the formula -N=C=N- in a molecule. Such a carbodiimide compound is not particularly limited and examples thereof include carbodiimide compounds in the form of the following paragraphs (a) to (e) and carbodiimide compounds obtained by introducing a functional chain (for example, carbodiimide compounds obtained by introducing a functional chain into carbodiimide compounds in the form of the paragraphs (a) to (e)).
First, the carbodiimide compounds in the form of the paragraphs (a) to (e) will be described.
(a) Carbodiimide compound having an isocyanate group, which is obtained by a decarboxylation reaction of a diisocyanate compound
The carbodiimide compound obtained by a decarboxylation reaction of a diisocyanate compound of the above paragraph (a) can be produced by converting the diisocyanate compound to carbodiimide by a decarboxylation reaction in the presence of a carbodiimidation catalyst in an organic solvent.
In the above-mentioned production method, examples of the diisocyanate compound, which undergoes a decarboxylation reaction, include aliphatic, alicyclic, aromatic or aromatic-aliphatic diisocyanate compounds such as hexamethylene diisocyanate, isophorone diisocyanate, tolylene diisocyanate, diphenylmethane diisocyanate, cyclohexane diisocyanate, dicyclohexylmethane diisocyanate, xylylene diisocyanate, tetramethylene diisocyanate and tetramethylxylylene diisocyanate.

As the above-mentioned organic solvent, a solvent having a high boiling point and not having an active hydrogen which reacts with an isocyanate compound and a produced compound having a carbodiimide group is preferably used, and examples of the solvent include aromatic hydrocarbons such as toluene, xylene and diethyl benzene; glycol ether esters such as diethylene glycol diacetate, dipropylene glycol dibutylate, hexylene glycol diacetate, glycol diacetate, methyl glycol acetate, ethyl glycol acetate, butyl glycol acetate, ethyl diglycol acetate and butyl diglycol acetate; ketones such as ethyl butyl ketone, acetophenone, propiophenone, diisobutyl ketone and cyclohexanone; and aliphatic esters such as amyl acetate, propyl propionate and ethyl butyrate.
As the above-mentioned carbodiimidation catalyst, phospholenes or phospholene oxides are preferably used, and examples of them include 1-ethyl-3-methyl-3-phospholene oxide, 1-phenyl-3-methyl-3-phospholene oxide, and 1-phenyl-3-methyl-2-phospholene oxide.

As a method of performing a decarboxylation reaction of an isocyanate group using these materials, known methods can be employed, and this reaction can be performed, for example, at a reaction temperature of 100 to 200°C in a nitrogen atmosphere. Incidentally, examples of other methods of obtaining the above-mentioned carbodiimide compound having an isocyanate group include the methods of USP No. 2941956, Japanese Kohyo Publication Sho47-33279, Japanese Kokai Hei5-178954, and Japanese Kokai Publication Hei6-56950.
With respect to a carbodiimide compound having an isocyanate group, which is obtained by using such the production methods, for example, a compound which is obtained by decarboxylating K moles (K ≥ 2) of a diisocyanate compound is expressed by the following general formula (11):

OCN-(A-N=C=N)_{K-1}-A-NCO (11)

In the above-mentioned general formula (11), A represents a residue which is the rest after eliminating isocyanate groups from the diisocyanate compound used for synthesis of a carbodiimide compound having an isocyanate group.
Examples of a commercially available product of a carbodiimide compound having isocyanate groups, expressed by the above general formula (11), include CARBODILITE V-03 and V-05 (all trade name, produced by NISSHINBO INDUSTRIES, INC) as carbodiimide made from tetramethylxylylene diisocyanate of a raw material.

(b) Carbodiimide compound obtained by further chain-extending a carbodiimide compound having isocyanate groups, which is obtained by a decarboxylation reaction of a diisocyanate compound, with a chain extender.
The carbodiimide compound of the above-mentioned paragraph (b) is formed by increasing a molecular weight of the carbodiimide compound of the above-mentioned paragraph (a) using a chain extender capable of reacting with an isocyanate group and it can be converted to a compound containing more carbodiimide groups in a molecule. As a chain extender which can be used in this case include, a compound having low reactivity with a carbodiimide group and selectively reacting with an isocyanate group first is preferred, and examples of the compound include a diol compound, a diamine compound, and hydrazine.

(c) Carbodiimide compound obtained by reacting a part of or all of the isocyanate groups of a carbodiimide compound having isocyanate groups, which is obtained by a decarboxylation reaction of a diisocyanate compound, with a compound having a functional group capable of reacting with isocyanate groups.
The carbodiimide compound of the above-mentioned paragraph (c) is obtained by reacting the carbodiimide compound of the above paragraph (a) with a compound having a functional group capable of reacting with isocyanate groups.
The above-mentioned compound having a functional group capable of reacting with isocyanate groups is preferably a compound having low reactivity with the carbodiimide group and selectively reacting with an isocyanate group first, and examples of such compounds include low molecular weight monoalcohol compounds such as methanol and ethanol; polyester compounds containing a hydroxyl group; polyether compounds containing a hydroxyl group; polyalkylene glycol and monoalkyl ester compounds thereof; and hydroxyl group-containing compounds like hydroxyl group-containing polyacrylic compounds such as polymethylmethacrylate diol and polybutyl methacrylate diol. Among others, carbodiimide compounds capable of forming a polyester chain, a polyether chain or a polyacrylic chain, having a formula weight of 500 to 5000 are preferred.

(d) Compound which is obtained by decarboxylating 2 moles of a monoisocyanate compound and K moles (K ≥ 1) of a diisocyanate compound, expressed by the following general formula (12):

B-N=C=N-(A-N=C=N)_{K}-B (12)

In the above-mentioned general formula (12), B represents a residue which is the rest after eliminating an isocyanate group from the monoisocyanate compound.
Examples of the above-mentioned monoisocyanate compound include aliphatic, alicyclic, aromatic or aromatic-aliphatic monoisocyanate compounds such as methyl isocyanate, ethyl isocyanate, propyl isocyanate, butyl isocyanate, octadecyl isocyanate and phenyl isocyanate.
Examples of the above-mentioned diisocyanate compound include the same compounds as that to be used in the above paragraph (a).

(e) Compound which is obtained by decarboxylating 1 mole of a monoisocyanate compound and K moles (K ≥ 1) of a diisocyanate compound, expressed by the following general formula (13):

OCN-(A-N=C=N)_{K}-B (13)

In the above-mentioned general formula (13), B represents a residue which is the rest after eliminating an isocyanate group from the monoisocyanate compound.
Examples of the above-mentioned monoisocyanate compound include the same compounds as that to be used in the above paragraph (d), and examples of the above-mentioned diisocyanate compound include the same compounds as that to be used in the above paragraph (a).

Next, a carbodiimide compound into which a functional chain is introduced will be described.
The above-mentioned carbodiimide compound, into which a functional chain is introduced, is a carbodiimide compound having at least one carbodiimide group, into which a functional chain is introduced in accordance with a pigment to be used and performance required of the pigment dispersion composition of the present invention. Specific examples of such the carbodiimide compound include carbodiimide compounds obtained by introducing a functional chain into carbodiimide compounds in the form of paragraphs (a) to (e) . Example of the functional chain include a basic nitrogen-containing chain (for the case of coating the pigment with the acid radical-containing reactant through the adsorption by an acid-base affinity), at least one kind selected from a colorant intermediate chain and a colorant derivative chain (for the case of coating the pigment with the acid radical-containing reactant through the adsorption by an affinity resulting from the similarity of a molecular structure), at least one kind selected from a polyester chain, a polyether chain and a polyacrylic chain (improvement in the stability of pigment dispersion), and a radical initiation chain and/or chain capable of sensitizing an ultraviolet light (for the case of requiring excellent curability or development characteristics).

### <Method of introducing basic nitrogen-containing chain into carbodiimide compound>

Examples of a method of introducing a basic nitrogen-containing chain into the carbodiimide compound include a method of reacting the carbodiimide compound in the form of the above paragraphs (a) to (e) with a compound having a functional group to react with the carbodiimide group and/or the isocyanate group and having a basic nitrogen-containing chain (when the basic nitrogen-containing chain is reacted with the carbodiimide group of the carbodiimide compound to be introduced, the carbodiimide compound having two or more carbodiimide groups is used as a carbodiimide compound so that at least one carbodiimide group remains in the obtained compound), and a method of reacting the carbodiimide compound having an isocyanate group of the above paragraph (a), (b), (c) or (e) with a compound having a functional group to react with the carbodiimide group and having a basic nitrogen-containing chain, and chain-extending the obtained compound and the carbodiimide compound having an isocyanate group of the above (a), (b), (c) or (e) with a chain extender.

Examples the above-mentioned compound having a functional group to react with the carbodiimide group and having a basic nitrogen-containing chain include a compound having an acid radical such as a carboxyl group which is suitable as a functional group capable of reacting with the carbodiimide group, and a tertiary amino group or a basic nitrogen-containing heterocyclic group which does not concern the reaction with the carbodiimide group or the isocyanate group. Examples of such a compound include dimethylaminobenzoic acid and diethylaminobenzoic acid.

Examples the above-mentioned compound having a functional group to react with the isocyanate group and having a basic nitrogen-containing chain include a compound having a hydroxyl group which is suitable as a functional group capable of selectively reacting with the isocyanate group, and a tertiary amino group or a basic nitrogen-containing heterocyclic group which does not concern the reaction with the carbodiimide group or the isocyanate group.
Examples of a compound having a hydroxyl group and a tertiary amino group include a N,N-dialkylalkanolamine compounds such as N,N-dimethylethanolamine and N,N-diethylethanolamine; ethylene oxide adducts such as a secondary amine compound; compounds having a hydroxyl group and a tertiary amino group such as reaction products of a secondary amine compound and an epoxy compound; N-alkyldialkanolamine compound such as N-ethyldiethanolamine and N-methyldiethanolamine; ethylene oxide adducts of primary amine compounds; and compounds having two hydroxyl groups and a tertiary amino group such as reaction products of a primary amine compound and an epoxy compound. As a compound having a hydroxyl group and a basic nitrogen-containing heterocyclic group, for example, pyridine, pyrazine, triazine or quinoline, etc., having a hydroxyl group and a heterocycle containing tertiary basic nitrogen, such as hydroxypyrazine, pyridinemethanol, and pyridineethanol can be used. Further, even a heterocycle compound containing secondary basic nitrogen such as piperazine or piperidine can be used by converting the compound to a tertiary one by an alkylation tratment and to a one having a hydroxyl group.

### <Method of introducing colorant intermediate chain and/or colorant derivative chain into carbodiimide compound>

Examples of a method of introducing a colorant intermediate chain and/or a colorant derivative chain into the above carbodiimide compound include a method of reacting the carbodiimide compound in the form of the above paragraphs (a) to (e) with a colorant intermediate and/or a colorant derivative having a functional group to react with the carbodiimide group and/or the isocyanate group (when the basic nitrogen-containing chain is reacted with the carbodiimide group of the carbodiimide compound to be introduced, the carbodiimide compound having two or more carbodiimide groups is used as a carbodiimide compound), and a method of reacting the carbodiimide compound having an isocyanate group of the above paragraph (a), (b), (c) or (e) with a colorant intermediate and/or a colorant derivative having a functional group to react with the carbodiimide group, and chain-extending the obtained compound and the carbodiimide compound having an isocyanate group of the above paragraph (a), (b), (c) or (e) with a chain extender.

The above-mentioned colorant intermediate means materials including both of a pigment intermediate and a dye intermediate and the above-mentioned colorant derivative refers to materials including both of a pigment derivative and a dye derivative, but most of readily available substances are compounds having a functional group capable of reacting with the carbodiimide group.
Further, examples of a functional group capable of reacting with the carbodiimide group, which the above-mentioned colorant intermediate and/or colorant derivative has, include a carboxyl group, a sulfonic acid group, a phosphoric acid group, a hydroxyl group and an amino group, and this functional group is preferably an acid radical of a carboxyl group, a sulfonic acid group or a phosphoric acid group.
Examples of the pigment intermediate of the above intermediates include a compound, used in synthesizing the pigment, having a functional group capable of reacting with the carbodiimide group such as naphthoic acid and 2-carboxypyrazine expressed by the following general formula (14). In addition, examples of the dye intermediate include a dye residue, being a compound used in synthesizing the dye or the like, and having a functional group capable of reacting with the carbodiimide group such as anthraquinone derivative described in Japanese Kokai Publication 2002-22922 and a pigment adsorbing site.

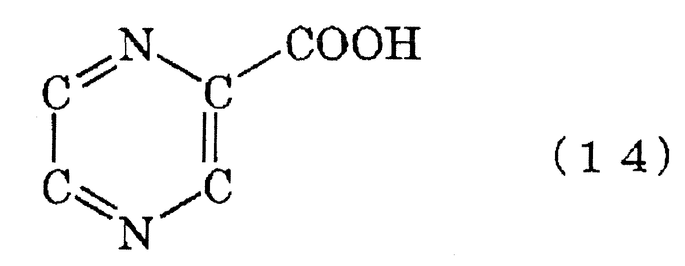

Further, examples of the pigment derivative include a compound having a functional group capable of reacting with the carbodiimide group, which are derivatives of a molecule of pigment described later. Also, examples of the dye derivative include a compound having a functional group capable of reacting with the carbodiimide group such as β-naphthol orange dye derivatives, which are derivatives of a molecule of dye or the like.
These colorant intermediates and colorant derivatives may be used singly or in combination of two or more kinds and it is preferred to appropriately select an optimum one according to the kind of a pigment to be used.

<Method of introducing polyester chain, polyether chain and polyacrylic chain into carbodiimide compound>
Examples of a method of introducing at least one kind of a chain selected from the group consisting of a polyester chain, a polyether chain and a polyacrylic chain in a molecule of the carbodiimide compound include the methods of the following paragraphs <1> to <3>. The polyester chain, the polyether chain or the polyacrylic chain introduced into the above-mentioned molecule is not particularly limited as long as it has an action of improving the dispersion stability of pigment in a dispersion medium, but for example, it preferably has a formula weight (number average molecular weight) of at least 200 and at most 10000. The number average molecular weight is more preferably at least 300 and at most 5000. A number average molecular weight of the above-mentioned polyester chain, polyether chain or polyacrylic chain is a value measured by a gel permeation chromatography method (GPC). The polyester chain, the polyether chain and the polyacrylic chain are preferably at least one kind of a side chain selected from the group consisting of a polyester side chain, a polyether side chain and a polyacrylic side chain. When the pigment has these chains to improve the dispersion stability of the pigment, it is assumed that the pigment can be dispersed more stably in a dispersion medium because these side chains form domains in the dispersion medium and exert an effect of steric hindrance in dispersing the pigment in the dispersion medium. Incidentally, the term "side chain" refers to a chain in a state of being branched from a principal chain assuming the carbodiimide compound to be a principal chain. In the present invention, a portion originated from the carbodiimide compound is referred to as a "principal chain" irrespective of the magnitude of a chain structure and all of chains in a state of being branched from the principal chain are referred to as a "side chain".

<1> Method of introducing the above-mentioned side chains into carbodiimide compound by reacting the carbodiimide group of the carbodiimide compound (for example, carbodiimide compounds in the form of the paragraphs (a) to (e)) with at least one kind of a compound selected from the group consisting of a polyester compound, a polyether compound and a polyacrylic compound having a functional group capable of reacting with the carbodiimide group. (the carbodiimide compound having two or more carbodiimide groups is used as a carbodiimide compound).
Hereinafter, the polyester compound, the polyether compound and the polyacrylic compound having a functional group capable of reacting with the carbodiimide group will be described.
Examples of the above-mentioned polyester compound having a functional group capable of reacting with the carbodiimide group include the following compounds.
(1) Ring-opening polymerization compounds of cyclic ester compounds using hydroxycarboxylic acid, monoalcohol, a low molecular weight diol compound or the like as an initiator (for example, polyester compounds containing a carboxyl group and a hydroxyl group, which are obtained by ring-opening polymerization of cyclic ester compounds such as ε-caprolactone, γ-butyrolactone, 2-methylcaprolactone, 4-methylcaprolactone, β-propiolactone, δ-valerolactone and β-methyl-δ-valerolactone, using monooxycarboxylic acid or polyoxycarboxylic acid such as lactic acid, caproic acid, 12-hydroxystearic acid, dimethylolpropionic acid and dimethylolbutanoic acid as a initiator; polyester monool compounds containing a hydroxyl group, which are obtained by ring-opening polymerization of the above-mentioned cyclic ester compounds, using a low molecular weight monool compound such as methanol and ethanol as an initiator; and polyester diol compounds containing a hydroxyl group, which are obtained by ring-opening polymerization of the above-mentioned cyclic ester compounds, using a low molecular weight diol compound such as ethylene glycol and propylene glycol as an initiator).
(2) Self-polycondensation compound of hydroxycarboxylic acid (for example, polyester compounds containing a carboxyl group and a hydroxyl group, which are obtained by polycondensating monohydroxycarboxylic acid such as lactic acid, caproic acid and 12-hydroxystearic acid).

(3) Compounds obtained by polycondensating a low molecular weight diol compound and a low molecular weight dicarboxylic acid compound (for example, polyester diol compounds containing a hydroxyl group, which are obtained by reacting a low molecular weight diol compound component such as liner glycols such as ethylene glycol, 1,3-propanediol, 1,4-butanediol or 1, 6-hexanediol, or branched glycols such as 1,2-propanediol, neopentyl glycol, 3-methyl-1,5-pentanediol or ethylbutylpropanediol with a low molecular weight dicarboxylic acid compound component such as saturated or unsaturated aliphatic dicarboxylic acids such as succinic acid, adipic acid, azelaic acid, sebacic acid or maleic acid, or aromatic dicarboxylic acids like phthalic acid in the presence of an excessive low molecular weight diol compound).
(4) Phosphate compounds of a ring-opening polymer of cyclic ester compounds using monoalcohol as an initiator (for example, polyester diol compounds containing a phosphoric acid group, which are obtained by esterifying the above-mentioned polyester monool compounds with phosphoric acid).
(5) Ring-opening polymerization compounds of cyclic ester compounds using an amino group-containing sulfonic acid compound as an initiator (for example, polyester diol compounds containing sulfonic acid, which are obtained by ring-opening polymerization of the above-mentioned cyclic ester compounds, using an amino group-containing sulfonic acid compound such as taurine as an initiator).
(6) Sulfur dioxide adduct of a ring-opening polymer of cyclic ester compounds using monoalcohol as an initiator (for example, polyester diol compounds containing sulfonic acid, which are obtained by adding sulfur dioxide to the above-mentioned polyester monool compounds).
   As such polyester compounds, polyester compounds obtained by ring-opening polymerization of polycaprolactone are preferred.

Examples of the above-mentioned polyether compound having a functional group capable of reacting with the carbodiimide group include the following compounds.
(1) Polyether monool compounds containing a hydroxyl group, which are obtained by ring-opening polymerization of cyclic ether compounds, using a low molecular weight monool compound such as methanol and ethanol as an initiator; and polyether diol compounds containing a hydroxyl group, which are obtained by ring-opening polymerization of cyclic ether compounds, using a low molecular weight diol compound such as ethylene glycol and propylene glycol as an initiator.
(2) Phosphate compounds of a ring-opening polymer of cyclic ether compounds using monoalcohol as an initiator (for example, polyether compounds containing a phosphoric acid group, which are obtained by esterifying the above-mentioned polyether monool compounds with phosphoric acid).
(3) Sulfur dioxide adduct of a ring-opening polymer of cyclic ether compounds using monoalcohol as an initiator (for example, polyether compounds containing sulfonic acid group, which are obtained by adding sulfur dioxide to the above-mentioned polyether monool compounds).

Examples of the above-mentioned polyacrylic compound having a functional group capable of reacting with the carbodiimide group include the following compounds.
(1) Polyacrylic compound obtained by polymerizing acid radical-not containing radically polymerizable unsaturated monomer including at least one kind of a acid radical-not containing acrylic monomer in the presence of an acid radical-containing chain transfer agent.

In addition to these compounds, further a compound having a functional group capable of reacting with the above carbodiimide group and containing both of a polyester chain and a polyether chain, a polyacrylic compound having a polyester chain, or a polyacrylic compound having a polyether chain may be used, and examples of such a compound include compounds obtained by reacting polyalkylene glycol or monoalkyl ether compounds thereof as an initiator with a cyclic ester compound; compounds obtained by reacting a hydroxyl group-containing polyester compound with a cyclic ether compound; and polyacrylic chain compounds obtained using (meth)acrylate monomer containing a polyester chain in a molecule or (meth)acrylate monomer containing a polyether chain in a molecule.
When the carbodiimide compound to be reacted further has a isocyanate group, if a compound having a hydroxyl group is used as a compound having a functional group capable of reacting with the carbodiimide group, the reaction with a isocyanate group takes place prior to the reaction with the carbodiimide group and the control of the reaction becomes difficult. Further, if a compound having two or more hydroxyl groups is used as a compound having a functional group capable of reacting with the carboxyl group, crosslinking takes place when the carbodiimide group of the carbodiimide compound forms a covalent bond with the functional group of the pigment, and therefore the pigment dispersion composition of the present invention may gelate.
Therefore, as for a compound having only a hydroxyl group as a functional group capable of reacting with the carbodiimide group, it is preferred to obtain a compound containing a carboxyl group by further reacting the compound with acid anhydride such as phthalic anhydride, maleic anhydride or succinic anhydride.

<2> Method of reacting the carbodiimide group of the carbodiimide compound (for example, carbodiimide compounds in the form of the paragraphs (a) to (e)) with a compound having a functional group capable of reacting with the carbodiimide group and then introducing a compound forming at least one kind of a side chain selected from the group consisting of a polyester chain and a polyether chain into a molecule (the carbodiimide compound having two or more carbodiimide groups is used as a carbodiimide compound).
In this method, the carbodiimide compound (for example, carbodiimide compounds in the form of the paragraphs (a) to (e)) is previously reacted with a compound having a functional group capable of reacting with the carbodiimide group and a functional group for introducing at least a side chain of a polyester side chain and a polyether side chain, and a side chain is introduced further by making use of these functional groups.
When the polyester side chain or the polyether side chain is introduced by this method, there is a method in which the carbodiimide group is reacted with hydroxycarboxylic acid first to introduce a hydroxyl group into a molecule of the polycarbodiimide compound and then a cyclic polyester compound or a cyclic polyether compound is polymerized by ring-opening to introduce the polyester side chain or the polyether side chain.

<3> Method of using a functional group to react with an isocyanate group to introduce at least one kind of a side chain selected from the group consisting of a polyester side chain and a polyether side chain.
A compound which can be used in such a method, being a one having two or more functional group capable of reacting with an isocyanate group, acts as a chain extender when both ends or either one end of the carbodiimide compound is an isocyanate group (for example, the carbodiimide compound, having an isocyanate group, of the above paragraph (a), (b), (c) or (e))and introduces the above side chain into a molecule.
Further, examples of a compound having a polyester chain include compounds obtained by ring-opening polymerization of a polyol compound having three or more hydroxyl groups such as trimethylolpropane and pentaerithritol with the above-mentioned cyclic polyester compounds; compounds obtained by polycondensating the above-mentioned low molecular weight diol compound partially together a triol compound with the above-mentioned low molecular weight dicarboxylic acid; and compounds obtained by reacting diolmonocarboxylic acid such as dimethylolpropionic acid with an epoxy compound having a polyester chain in a molecule.
Further, examples of a compound having a polyether chain include compounds obtained by ring-opening polymerization of the above polyol compound with the above-mentioned cyclic polyether compounds.

<Method of introducing radical initiation chain and/or chain capable of sensitizing an ultraviolet light into carbodiimide compound>
Examples of a method of introducing a radical initiation chain and/or a chain capable of sensitizing an ultraviolet light into the above carbodiimide compound include a method of reacting the carbodiimide compound in the form of the above paragraphs (a) to (e) with a compound having a radical initiation ability and/or a compound having a capability of sensitizing an ultraviolet light, having a functional group to react with the carbodiimide group and/or the isocyanate group (when the colorant intermediate chain and/or the colorant derivative chain is reacted with the carbodiimide group, the carbodiimide compound having two or more carbodiimide groups is used as a carbodiimide compound), and a method of reacting the carbodiimide compound, having an isocyanate group, of the above paragraph (a), (b), (c) or (e) with a compound having a radical initiation ability and/or a compound having a capability of sensitizing an ultraviolet light having a functional group to react with the carbodiimide group and chain-extending the obtained compound and the carbodiimide compound, having an isocyanate group, of the above paragraph (a), (b), (c) or (e) with a chain extender.
First, a compound having a functional group to react with the carbodiimide group and/or the isocyanate group and having radical initiation ability, which is used to obtain a carbodiimide compound having radical initiation chain, will be described.
In the above-mentioned compound which has a functional group to react with the carbodiimide group and radical initiation ability, example of the functional group to react with the carbodiimide group include a carboxyl group, a sulfonic acid group, a phosphoric acid group, a hydroxyl group and an amino group, and this functional group is preferably an acid radical of a carboxyl group, a sulfonic acid group or a phosphoric acid group.
Examples of a compound having such a functional group and having radical initiation ability include benzoylbenzoic acid.
In the above-mentioned compound which has a functional group to react with the isocyanate group and radical initiation ability, the functional group to react with the isocyanate group may be a group having low reactivity with the carbodiimide group and selectively reacting with the isocyanate group first, and for example, it is preferably a hydroxyl group. Examples of a compound having such a functional group and having radical initiation ability include l-[4-(2-hydroxyethoxy)-phenyl]-2-hydroxy-2-methyl-l-propane -1-on, and 1-hydroxycyclohexylphenyl ketone.

Next, a compound having a functional group to react with the carbodiimide group and/or the isocyanate group and having a capability of sensitizing an ultraviolet light, which is used to obtain a carbodiimide compound having a chain capable of sensitizing an ultraviolet light, will be described.
As the above-mentioned compound which has a functional group to react with the carbodiimide group and a capability of sensitizing an ultraviolet light, for example, dimethylaminobenzoic acid and diethylaminobenzoic acid are suitably used.
Further, as the above-mentioned compound which has a functional group to react with the isocyanate group and a capability of sensitizing an ultraviolet light, N-alkyldialkanolamine such as N-ethyldiethanolamine and N-methyldiethanolamine is suitably used.
In addition, the compound having a capability of sensitizing an ultraviolet light referred to here is a compound also containing basic nitrogen.

It is also possible to introduce two or more of the above-mentioned basic nitrogen-containing chain, colorant intermediate chain, colorant derivative chain, polyester chain, polyether chain, polyacrylic chain, radical initiation chain and chain capable of sensitizing an ultraviolet light into the above-mentioned carbodiimide compound as a functional chain in accordance with a kind of a pigment to be used in the present invention and performance required for the pigment dispersion composition of the present invention.
In addition, the carbodiimide compound described above may be used singly or in combination of two or more kinds.

The above-mentioned carbodiimide compound is preferably a carbodiimide compound with a carbodiimide equivalent of 100 to 50000. Here, the carbodiimide equivalent refers to a number expressed by (a molecular weight of carbodiimide compound) / (number of the carbodiimide groups in a carbodiimide compound molecule). This number is more preferably at least 200 and at most 10000.

Next, an acid radical-containing resin composing the pigment dispersion composition of the present invention will be described.
As the above-mentioned acid radical-containing resin, an acid radical-containing copolymer resin, an acid radical-containing polyester resin, and an acid radical-containing urethane resin are exemplified.
Particularly preferred one is an acid radical-containing copolymer resin obtained by radically polymerizing a monomer component containing at least one kind of monomers having an acid radical, and specifically an acid radical-containing copolymer resin obtained by radically polymerizing an acid radical-containing unsaturated monomer component such as acrylic acid, methacrylic acid, itaconic acid, maleic acid, maleic anhydride, monoalkyl maleate ester, citraconic acid, citraconic anhydride, monoalkyl citraconate ester, sulfoethyl methacrylate, butylacrylamidesulfonic acid or phosphoethyl methacrylate with at least one kind of monomer component selected from the group consisting of styrene, 2-hydroxyethyl acrylate, 2-hydroxyethyl methacrylate, allyl acrylate, allyl methacrylate, benzyl acrylate, benzyl methacrylate, glycerol monoacrylate, glycerol methacrylate, N-phenylmaleimide, polystyrene macromonomer and polymethyl methacrylate macromonomer.

Examples of an acid radical of the above-mentioned acid radical-containing resin include a carboxyl group, a sulfonic acid group and a phosphoric acid group.
The acid radical-containing resin used in the present invention has an acid value of 20 to 300 mgKOH/g and a weight average molecular weight of 1000 to 100000. A preferred lower limit of the above acid value is 25 mgKOH/g and a preferred upper limit of the above acid value is 250 mgKOH/g.
In the present invention, a weight average molecular weight of the above acid radical-containing resin is a value measured by a gel permeation chromatography method (GPC) . The above acid radical-containing resin increases in viscosity when the weight average molecular weight exceeds 100000. A preferred upper limit of the weight average molecular weight is 60000.
In addition, these resins can be used singly or in combination of two or more kinds.

Next, a pigment composing the pigment dispersion composition of the present invention will be described.
The pigment used in the present invention is not particularly limited and an inorganic pigment or an organic pigment previously used can be used, but a pigment preferably adsorbs to the carbodiimide compound through at least a covalent bond, an acid-base affinity or an affinity resulting from the similarity of a molecular structure and for example, an organic pigment or an inorganic pigment commonly used in the resist compositions for a color filter can be used.

First, a pigment having the property of covalently bonding to a carbodiimide compound having a carbodiimide group in a molecule is suitably a pigment having a functional group to react with the carbodiimide group, and among others, an organic pigment or an inorganic pigment having at least one kind of a functional group selected from the group consisting of a carboxyl group, a sulfonic acid group, a phosphoric acid group, a hydroxyl group and an amino group is preferable.
Examples of the above-mentioned organic pigment include dye lake pigment, azo pigment, benzimidazolone pigment, phthalocyanine pigment, quinacridone pigment, anthraquinone pigment, dioxazine pigment, indigo pigment, thioindigo pigment, perylene pigment, perynone pigment, diketopyrrolopyrrole pigment, isoindolinone pigment, nitro pigment, nitroso pigment, anthraquinone pigment, flavanthrone pigment, quinophthalone pigment, pyranthrone pigment and indathrone pigment, and examples of the above-mentioned inorganic pigment include carbon black (preferably having a pH of 7 or less and a carboxyl group), titanium oxide, red oxide, graphite, iron black, chromic oxide green and aluminum hydroxide.
Further, in the case of not having the functional group to react with the carbodiimide group at the surface of a pigment, the functional group can be introduced by surface treatment and for example, the functional group capable of reacting with the above carbodiimide group can be introduced by a plasma treatment or a oxygen/ultraviolet light treatment described in "Ganryo Bunsan Anteika to Hyomen Shori Gijyutsu · Hyoka (Stability of Pigment Dispersion and Surface Treatment Technique · Evaluation)" (1st edition, TECHNICAL INFORMATION INSTITUTE CO., LTD., December 25 (2001), p.76-85), or a low temperature plasma process described in Japanese Kokai Publication Sho58-217559. Further, the functional group to react with the carbodiimide group can also be introduced by coating the pigment with an insulating compound (silica, silane compounds, titanium compounds).

Next, a pigment having a site adsorbing to a carbodiimide compound having a basic nitrogen-containing chain in a molecule through an acid-base affinity is preferably an organic pigment or an inorganic pigment having a site adsorbing to a basic nitrogen-containing group at the surface of a pigment.
The above-mentioned site adsorbing to a basic nitrogen-containing group is typically an acid radical, and preferably a functional group which can adsorb to the basic nitrogen-containing groups such as a carboxyl group, a sulfonic acid group and a phosphoric acid group.
Examples of the organic pigment having a site adsorbing to these basic nitrogen-containing group include dye lake pigment, azo pigment, benzimidazolone pigment, phthalocyanine pigment, quinacridone pigment, anthraquinone pigment, dioxazine pigment, indigo pigment, thioindigo pigment, perylene pigment, perynone pigment, diketopyrrolopyrrole pigment, isoindolinone pigment, nitro pigment, nitroso pigment, anthraquinone pigment, flavanthrone pigment, quinophthalone pigment, pyranthrone pigment and indathrone pigment, and examples of the inorganic pigment include carbon black (preferably having a pH of 7 or less and a carboxyl group).
In addition, even when the pigment does not have a site adsorbing to the basic nitrogen-containing group, the carboxyl group or the sulfonic acid group can be introduced by treating by a normal method of introducing a functional group such as derivative treatment or sulfonation treatment of the surface of a pigment.

Next, a pigment having a site adsorbing to a carbodiimide compound having a colorant intermediate chain and/or a colorant derivative chain in a molecule through an affinity resulting from the similarity of a molecular structure is preferably an organic pigment or an inorganic pigment having a structure which is identical to or similar to the colorant intermediate and/lor the colorant derivative; or an organic pigment or an inorganic pigment not having a structure which is identical to or similar to the colorant intermediate and/or the colorant derivative but having a sufficient adsorbing force to the colorant intermediate and/or the colorant derivative.
Such the adsorption by an affinity resulting from the similarity of a molecular structure is more effective, for example, for the pigment not having a functional group capable of reacting with the carbodiimide group and/or the isocyanate group (the case where a covalent bond is not available); and the pigment having a functional group which is capable of reacting with the carbodiimide group but is for example an amino group or a hydroxyl group and reacts with the carbodiimide group at a temperature of 100°C or higher (the case where the utilization of a covalent bond is conditionally difficult).

As such a combination of a colorant intermediate and/or a colorant derivative and a pigment, (1) as for phthalocyanine pigment derivatives as a pigment derivative, there is a combination with pigment black 7 in addition to a phthalocyanine pigment as a pigment, (2) as for β-naphthol orange dye derivatives as a dye derivative, there is a combination with condensated azo pigment in addition to a naphthol pigment as a pigment, and (3) as for anthraquinone derivatives as a dye intermediate, there is a combination with diketopyrrolopyrrole pigment, condensated azo pigment, isoindoline pigment, perynone pigment, azo pigment having a heteroring, quinacridone pigment, dibromoanthanthrone and/or benzimidazolone pigment in addition to a dianthraquinonyl pigment as a pigment.
The above-mentioned pigment may be used singly or in combination of two or more kinds.
An amount of the pigment to be used in the above-mentioned pigment dispersion composition is preferably 5 to 97% by mass with respect to the total solid content of the pigment dispersion composition.

Next, a dispersion medium composing the pigment dispersion composition of the present invention will be described.
As the dispersion medium to be used in the present invention, an organic dispersion medium and an aqueous medium can be used.
Examples of the organic dispersion mediums include (poly) alkylene glycol monoalkyl ethers such as ethylene glycol monomethyl ether, ethylene glycol monoethyl ether, diethylene glycol monomethyl ether, diethylene glycol monoethyl ether, propylene glycol monomethyl ether and propylene glycol monoethyl ether; (poly)alkylene glycol monoalkyl ether acetates such as ethylene glycol monomethyl ether acetate, ethylene glycol monoethyl ether acetate and propylene glycol monomethyl ether acetate; ethers such as diethylene glycol diethyl ether, diethylene glycol methylethyl ether and tetrahydrofuran; ketones such as methyl ethyl ketone, methyl isobutyl ketone, cyclohexanone, 2-heptanone and 3-heptanone; alkyl lactates such as methyl 2-hydroxypropionate and ethyl 2-hydroxypropionate; esters such as ethyl 2-hydroxy-2-methylpropionate, 3-methyl-3-methoxybutylpropionate, methyl 3-methoxypropionate, ethyl 3-ethoxypropionate, ethyl ethoxyacetate, ethyl hydroxyacetate, ethyl acetate, n-butyl acetate, i-butyl acetate, n-butyl propionate, methyl acetoacetate, n-amyl formate and ethyl pyruvate; aromatic hydrocarbons such as toluene and xylene; amides such as N-methylpyrrolidone, N,N-dimethylformamide and N,N-dimethylacetoamide; and alcohols such as isopropyl alcohol and n-propyl alcohol.
Further, as an aqueous medium, water may be used singly or in combination with an organic dispersion medium miscible with water. In addition, theses dispersion mediums may be used singly or in a mixture of two or more kinds.
The above dispersion mediums are appropriately selected in accordance with the applications of a pigment dispersion composition and desired properties.

The total content of the acid radical-containing resin and the carbodiimide compound in the pigment dispersion composition of the present invention is preferably 10% by mass or more and more preferably 20% by mass or more with respect to 100% by mass of the pigment, and it is 100% by mass or less. Further, it is preferred that the contents of these compounds are appropriately adjusted in accordance with required performance such as kind of a pigment, dispersion performance, fluidity and development characteristics. In addition, preferred contents of the carbodiimide compound and the acid radical-containing resin in the pigment dispersion composition of the present invention varies with the production methods of the pigment dispersion composition.

Next, a method of producing the pigment dispersion composition of the present invention will be described.
As the method of producing the pigment dispersion composition of the present invention, the following methods (1), (2) and (3) can be employed.
(1) A method comprising the steps of: coating the surface of a pigment using an acid radical-containing reactant obtained by reacting a carbodiimide compound having at least one carbodiimide group with an acid radical-containing resin having an acid value of 20 to 300 mgKOH/g and a weight average molecular weight of 1000 to 100000 in advance; and dispersing the pigment in a dispersion medium (reaction system).
   In this method, the reaction is performed on condition that all of the carbodiimide groups of the carbodiimide compound reacts with the acid radical of the acid radical-containing resin to form a covalent bond and further an acid radical remains in a molecule of the obtained acid radical-containing reactant. Since the acid radical-containing reactant obtained in this reaction does not have a carbodiimide group, a covalent bond between the acid radical-containing reactant and the functional group at the surface of the pigment is not produced and the acid radical-containing reactant adsorbs on the surface of the pigment through adsorption by an acid-base affinity and adsorption by an affinity resulting from the similarity of a molecular structure, and thereby the surface of the pigment is coated. In addition, as the carbodiimide compound to be used here, a carbodiimide compound, into which the functional chains such as the basic nitrogen-containing chain, the colorant intermediate chain and the colorant derivative chain are introduced, is preferred. When the functional chains such as the basic nitrogen-containing chain, the colorant intermediate chain and the colorant derivative chain are introduced, it is preferred to react the carbodiimide compound with a compound, into which the functional chain is introduced, on condition that a carbodiimide group remains, in advance prior to the reaction of the carbodiimide compound with the acid radical-containing resin.
   In the above production method of paragraph (1), preferred amounts of the carbodiimide compound and the acid radical-containing resin to be mixed are appropriately adjusted in such a way that the equivalent of the total acid radical of the acid radical-containing resin is larger than the total carbodiimide equivalent of the carbodiimide compound and the obtained acid radical-containing reactant does not gelate.

(2) A method comprising the steps of: coating the surface of a pigment by pre-treating the surface of a pigment with a carbodiimide compound having at least one carbodiimide group and then reacting a residual carbodiimide group in the carbodiimide compound with an acid radical-containing resin having an acid value of 20 to 300 mgKOH/g and a weight average molecular weight of 1000 to 100000; and dispersing the pigment in a dispersion medium.
In this method, examples of a method of treating the surface of a pigment with the carbodiimide compound include the following methods 1) and 2) in accordance with the kind of the pigment.
1) When the functional group to react with the carbodiimide groups of the carbodiimide compound exists at the surface of a pigment, a covalent bond is formed between the carbodiimide group of the carbodiimide compound and the functional group at the surface of the pigment.
   In this case, the reaction between the carbodiimide group and the functional group at the surface of the pigment is performed on condition that an unreacted carbodiimide group remains in the carbodiimide compound. Next, an acid radical-containing resin is added to react the unreacted carbodiimide group with the acid radical which the acid radical-containing resin has. In this case, the acid radical-containing resin is added on condition that an acid radical remains in a molecule of the obtained acid radical-containing reactant. In addition, as the carbodiimide compound to be used here, carbodiimide compounds in the form of the above-mentioned paragraphs (a) to (e) and carbodiimide compounds obtained by introducing a functional chain are suitable.
2) When the functional group to react with the carbodiimide groups of the carbodiimide compound does not exist at the surface of a pigment, the carbodiimide compound is adsorbed on the surface of the pigment through an acid-base affinity and an affinity resulting from the similarity of a molecular structure.
   Next, an acid radical-containing resin is added to react the carbodiimide group of the carbodiimide compound with the acid radical which the acid radical-containing resin has. In this case, the acid radical-containing resin is added on condition that an acid radical remains in a molecule of the obtained acid radical-containing reactant. In addition, as the carbodiimide compound to be used here, a carbodiimide compound, into which the functional chains such as the basic nitrogen-containing chain, the colorant intermediate chain and the colorant derivative chain are introduced, is preferred.
   Preferred amounts of the carbodiimide compound and the acid radical-containing resin to be mixed are appropriately adjusted in such a way that the equivalent of the total acid radical of the acid radical-containing resin is larger than the equivalent of the carbodiimide group not having reacted with a functional group at the surface of a pigment in the above case

1) and in such a way that the equivalent of the total acid radical of the acid radical-containing resin is larger than the total carbodiimide equivalent of the carbodiimide compound in the above case 2), and the obtained pigment dispersion composition does not gelate in the both cases 1) and 2).

(3) A method comprising the steps of: coating the surface of a pigment by conducting a reaction in a mixture containing at least a pigment, a carbodiimide compound having at least one carbodiimide group, and an acid radical-containing resin having an acid value of 20 to 300 mgKOH/g and a weight average molecular weight of 1000 to 100000; and dispersing the pigment in a dispersion medium (mixture system).
In this method, when the functional group to react with the carbodiimide groups of the carbodiimide compound exists at the surface of a pigment, a covalent bond between the functional group at the surface of the pigment and the carbodiimide group is formed and the reaction of the carbodiimide group with the acid radical of the acid radical-containing resin takes place, and thereby the surface of the pigment is coated with a acid radical-containing reactant. In addition, in the case where the functional group to react with the carbodiimide groups exists at the surface of a pigment, any of the reaction of the carbodiimide group of the carbodiimide compound with the functional group at the surface of the pigment, and the reaction of the carbodiimide group of the carbodiimide compound with the acid radical of the acid radical-containing resin may be performed first as long as the pigment dispersion composition ultimately has the same structure as that obtained by the method of the above paragraph (2) 1). As the carbodiimide compound to be used here, carbodiimide compounds in the form of the above-mentioned paragraphs (a) to (e) and carbodiimide compounds obtained by introducing a functional chain are suitable.
Further, when the functional group to react with the carbodiimide groups of the carbodiimide compound does not exist at the surface of a pigment, the reaction of the carbodiimide group of the carbodiimide compound with the acid radical of the acid radical-containing resin, the adsorption by an acid-base affinity and the adsorption by an affinity resulting from the similarity of a molecular structure take place, and thereby the acid radical-containing reactant is coated on the surface of a pigment. In addition, any of the reaction of the carbodiimide group of the carbodiimide compound with the acid radical of the acid radical-containing resin, and the adsorption by an acid-base affinity and the adsorption by an affinity resulting from the similarity of a molecular structure may be performed first as long as the pigment dispersion composition ultimately has the same structure as that obtained by the method of the above paragraphs (1) and (2) 2). As the carbodiimide compound to be used here, a carbodiimide compound, into which the functional chains such as the basic nitrogen-containing chain, the colorant intermediate chain and the colorant derivative chain are introduced, is preferred.
In the above production method of paragraph (3), the reaction is carried out on condition that in any case, an acid radical remains in a molecule of the obtained acid radical-containing reactant and the obtained pigment dispersion composition does not gelate.

In the above methods (1) to (3), a method of dispersing a pigment in a dispersion medium is not particularly limited and a publicly known method can be employed.
In the above methods (1) to (3), the step of dispersing a pigment in a dispersion medium may be performed after performing the step of coating the surface of a pigment or these steps may be simultaneously performed, but it is preferred to perform simultaneously these steps.

In the above-mentioned method of producing the pigment dispersion composition, as a method of the reaction between the carbodiimide group of the carbodiimide compound and a carboxyl group, a sulfonic acid group, a phosphoric acid group, a hydroxyl group or an amino group which the compound to be used in introducing the functional chain into the carbodiimide compound, the acid radical-containing resin or the pigment has, and as a method of the reaction between the isocyanate group of the carbodiimide compound and a hydroxyl group or an amino group which the compound to be used in introducing the functional chain into the carbodiimide compound has, normal methods can be employed.

For producing the pigment dispersion composition of the present invention using a pigment, a carbodiimide compound, a acid radical-containing reactant and a dispersion medium, in addition to these components, a complementary color pigment and other additives may be added as required. Further, for kneading and dispersing these mixtures, the above-mentioned roller mill, a kneader, a high speed mixing equipment, a bead mill, a ball mill, a sand mill, an ultrasonic dispersion apparatus, and a high pressure dispersing apparatus can be used. Further, kneading and dispersing of the mixture can be done at relatively low temperatures, but it is more preferred to heat the mixture to a temperature at which the reaction of the carbodiimide group of the carbodiimide compound with the acid radical of the acid radical-containing resin and the reaction of the carbodiimide group of the carbodiimide compound with the functional group capable of reacting with a carbodiimide group at the surface of the pigment are accelerated to perform kneading and dispersing.
In the production of the pigment dispersion composition of the present invention, it is preferred that the amounts of the acid radical-containing resin and the carbodiimide compound and kind and ratio of the functional chain introduced into the carbodiimide compound are appropriately determined in accordance with kind of a pigment and performance required in application areas and the respective materials are mixed in such a way that the ultimate composition can achieve good performance.

The pigment dispersion composition of the present invention thus obtained has good fluidity and dispersion stability and it exhibits excellent development characteristics when it is used for applications requiring alkaline development.
The pigment dispersion composition of the present invention will be suitably used in the areas of an printing ink, a coating material, a pigment dispersion resist compositions for a liquid crystal color filter or for a black matrix, (ultraviolet-curable) ink for ink jet, ink for writing materials, a ribbon ink, and a liquid developing agent by further containing various binder resins, a solvent, a surfactant, and other various additives as required.

The pigment dispersion resist compositions for a liquid crystal color filter or for a black matrix, which is an example of preferred applications of the pigment dispersion composition of the present invention, will be described in more detail. The above-mentioned pigment dispersion resist composition has curability by active energy rays, and is a resist composition which can be developed with alkali, and is predominantly composed of a pigment, a carbodiimide compound, a film forming resin, a photopolymerizable compound, a photopolymerization initiator and a solvent, and appropriately contains various additives such as a sensitizer and a polymerization inhibitor as required. The pigment dispersion resist composition of the present invention is obtained by adding various additives such as a film forming resin, a photopolymerizable compound, a photopolymerization initiator, a solvent, a sensitizer and a polymerization inhibitor to the above-mentioned pigment dispersion composition according to the purpose.

First, pigments to be used for the pigment dispersion resist compositions for the black matrix and for the color filter of the present invention will be described.
Examples of a representative pigment composing the above-mentioned pigment dispersion resist composition for the black matrix include carbon black. As the carbon black, carbon black having a average primary particle diameter of 0.15 µm or less is preferably used, and when such carbon black is dispersed, it is preferred to mix a complementary color pigment as required and to set a hue at neutral black.
Further, as the organic pigment composing the pigment dispersion resist composition for the color filter, it is preferred to use a high-grade pigment in order to form a film having a vivid hue.
An amount of these pigments to be used is preferably 5 to 80% by mass with respect to the total solid content of the pigment dispersion resist composition.
As a film forming resin composing the above-mentioned pigment dispersion resist composition, for example, alkali-soluble resins having a carboxyl group, which are copolymers obtained by reacting a carboxyl group-containing unsaturated monomer such as acrylic acid, methacrylic acid, itaconic acid, maleic acid, maleic anhydride, monoalkyl maleate ester, citraconic acid, citraconic anhydride and monoalkyl citraconate ester with at least one kind selected from the group consisting of styrene, 2-hydroxyethyl acrylate, 2-hydroxyethyl methacrylate, allyl acrylate, allyl methacrylate, benzyl acrylate, benzyl methacrylate, glycerol monoacrylate, glycerol methacrylate, N-phenylmaleimide, polystyrene macromonomer and polymethyl methacrylate macromonomer, can be exemplified, and these can be used singly or in combination of two or more kinds.

Examples of the photopolymerizable compound composing the above-mentioned pigment dispersion resist composition include a monomer and an oligomer, having a photopolymerizable unsaturated bond.
As a monomer having a photopolymerizable unsaturated bond in a molecule, for example, alkyl methacrylate or alkyl acrylate such as methyl methacrylate, butyl methacrylate, 2-ethylhexyl methacrylate, methyl acrylate, butyl acrylate and 2-ethylhexyl acrylate; aralkyl methacrylate or aralkyl acrylate such as benzyl methacrylate and benzyl acrylate; alkoxyalkyl methacrylate or alkoxyalkyl acrylate such as butoxyethyl methacrylate and butoxyethyl acrylate; aminoalkyl methacrylate or aminoalkyl acrylate such as N,N-dimethylaminoethyl methacrylate and N,N-dimethylaminoethyl acrylate; methacrylate or acrylate of polyalkylene glycol monoalkyl ether such as diethylene glycol monoethyl ether, triethylene glycol monobutyl ether and dipropylene glycol monomethyl ether; methacrylate or acrylate of polyalkylene glycol monoaryl ether such as hexaethylene glycol monophenyl ether; isobonyl methacrylate or isobonyl acrylate; glycerol methacrylate or glycerol acrylate; and 2-hydroxyethyl methacrylate or 2-hydroxyethyl acrylate can be exemplified.

As a monomer having two or more photopolymerizable unsaturated bonds in a molecule, for example, bisphenol A dimethacrylate, 1,4-butanediol dimethacrylate, 1,3-butyleneglycol dimethacrylate, diethyleneglycol dimethacrylate, glycerol dimethacrylate, neopentylglycol dimethacrylate, polyethyleneglycol dimethacrylate, polypropyleneglycol dimethacrylate, tetraethyleneglycol dimethacrylate, trimethylolpropane trimethacrylate, pentaerythritol trimethacrylate, pentaerythritol tetramethacrylate, dipentaerythritol tetramethacrylate, dipentaerythritol hexamethacrylate, dipentaerythritol pentamethacrylate, bisphenol A diacrylate, 1,4-butanediol diacrylate, 1,3-butyleneglycol diacrylate, diethyleneglycol diacrylate, glycerol diacrylate, neopentylglycol diacrylate, polyethyleneglycol diacrylate, polypropyleneglycol diacrylate, tetraethyleneglycol diacrylate, trimethylolpropane triacrylate, pentaerythritol triacrylate, pentaerythritol tetraacrylate, dipentaerythritol tetraacrylate, dipentaerythritol hexaacrylate, and dipentaerythritol pentaacrylate can be exemplified.
As the oligomer having a photopolymerizable unsaturated bond, a polymer obtained by polymerizing one or two or more kinds of the above-mentioned monomers appropriately can be used.
These photopolymerizable compounds can be used singly or in combination of two or more kinds.

The photopolymerization initiator composing the above-mentioned pigment dispersion resist composition is not particularly limited and it includes, for example, photopolymerization initiators such as benzophenone, N,N'-tetraethyl-4,4'-diaminobenzophenone, 4-methoxy-4'-dimethylaminobenzophenone, benzyl, 2,2-diethoxyacetophenone, benzoin, benzoin methyl ether, benzoin isobutyl ether, benzyldimethyl ketal, α-hydroxyisobutylphenone, thioxanthone, 2-chlorothioxanthone, 1-hydroxycyclohexylphenyl ketone, t-butylanthraquinone, 1-chloroanthraquinone, 2,3-dichloroanthraquinone, 3-chlor-2-methylanthraquinone, 2-ethylanthraquinone, 1,4-naphthoquinone, 1,2-benzoanthraquinone, 1,4-dimethylanthraquinone, 2-phenylanthraquinone, and triazine-based photopolymerization initiator. These compounds may be used singly or in combination of two or more kinds.

Examples of the solvent composing the above-mentioned pigment dispersion resist composition are similar to those of the dispersion medium described above, but they are preferably ester organic solvents, ether organic solvents, ether ester organic solvents, ketone organic solvents, aromatic hydrocarbon solvents, and nitrogen-containing organic solvents, which have a boiling point of 100 to 220°C at normal pressure (1.013×10² kPa). If the resist composition contains a large amount of an organic solvent having a boiling point of higher than 220°C, in pre-baking a coat applied and formed, the organic solvent is not adequately evaporated and remains within a dried coat and therefore the heat resistance of the dried coat may be deteriorated. Further, if the resist composition contains a large amount of an organic solvent having a boiling point of lower than 100°C, it becomes difficult to apply the resist composition evenly and uniformly and there may be cases where a coat having excellent surface smoothness is not obtained.
As a preferred solvent, specifically, ether organic solvents such as ethylene glycol monomethyl ether, ethylene glycol monoethyl ether, ethylene glycol monoisopropyl ether, ethylene glycol monobutyl ether, diethylene glycol monomethyl ether, diethylene glycol monoethyl ether, propylene glycol monomethyl ether, propylene glycol monoethyl ether, propylene glycol monobutyl ether, diethylene glycol diethyl ether, diethylene glycol dimethyl ether and diethylene glycol methylethyl ether; ether ester organic solvents such as ethylene glycol monomethyl ether acetate, ethylene glycol monoethyl ether acetate, ethylene glycol monobutyl ether acetate, propylene glycol monomethyl ether acetate and propylene glycol monoethyl ether acetate; ketone organic solvents such as methyl isobutyl ketone, cyclohexanone, 2-heptanone and δ-butyrolactone; ester organic solvents such as 2-hydroxypropionic acid methyl ester, 2-hydroxypropionic acid ethyl ester, 2-hydroxy-2-methylpropionic acid ethyl ester, 3-methyl-3-methoxybutylpropionate, methyl 3-methoxypropionate, ethyl 3-methoxypropionate, methyl 3-ethoxypropionate, ethyl 3-ethoxypropionate, ethyl ethoxyacetate, ethyl hydroxyacetate and n-amyl formate; and nitrogen-containing organic solvents such as N-methylpyrrolidone, N,N-dimethylformamide and N,N-dimethylacetoamide can be exemplified, and theses solvent may be used singly or in a mixture of two or more kinds.

Among these organic solvents, in point of solubility, dispersibility and a applying property, diethylene glycol dimethyl ether, diethylene glycol methylethyl ether, ethylene glycol monomethyl ether acetate, propylene glycol monomethyl ether acetate, propylene glycol monoethyl ether acetate, cyclohexanone, 2-heptanone, 2-hydroxypropionic acid ethyl ester, 3-methyl-3-methoxybutylpropionate, ethyl 3-methoxypropionate, methyl 3-ethoxypropionate, and n-amyl formate are preferred, and propylene glycol monomethyl ether acetate is more preferred.
Further, the content of these organic solvents are preferably 50% by mass or more and more preferably 70% by mass or more of the total organic solvent used in the above-mentioned pigment dispersion resist composition in point of solubility, pigment dispersibility and a applying property of the above-mentioned alkali-soluble resin.

In the above-mentioned pigment dispersion resist composition, other various additives such as a photopolymerizable compound, a thermal polymerization inhibitor, an ultraviolet absorber and an antioxidant other than the above-mentioned substances can be appropriately used as required.
As a method of producing the pigment dispersion resist composition of the present invention using the above-mentioned materials, for example, a method of adding a photopolymerizable compound, a photopolymerization initiator, a film forming resin, an organic solvent and other additives to the pigment dispersion composition according to the purpose and stirring/mixing the resulting mixture with mixing equipment can be employed, but this production method is an example of the preferred embodiments of the present invention and the present invention is not limited to this example.
A pigment dispersion resist composition containing the above pigment dispersion composition also constitutes the present invention.

The compound for pigment treatment of the present invention is obtained by reacting the carbodiimide compound having at least one carbodiimide group described above with an acid radical-containing resin having an acid value of 20 to 300 mgKOH/g and a weight average molecular weight of 1000 to 100000 and further has an acid radical in a molecule.

### EFFECT OF THE INVENTION

The pigment dispersion composition of the present invention exhibits excellent development characteristics particularly when it is used for the areas requiring development characteristics such as a resist composition for a color filter or a resist composition for a black matrix since the surface of the pigment in this composition is coated with an acid radical-containing reactant produced by the reaction of a carbodiimide compound with an acid radical-containing resin.

### BEST MODES FOR CARRYING OUT THE INVENTION

Hereinafter, the present invention will be described specifically by way of examples, but the present invention is not limited to these examples as long as it does not depart from the gist and the applicable scope of the invention.

### <Measurement of acid radical>

It was determined whether an acid radical remained or not in the obtained acid radical-containing carbodiimide compound based on the presence or absence of the peaks of infrared rays with a wavelength of 1700 cm⁻¹ using a infrared spectrometer FTIR 8100A (manufactured by SHIMADZU CORPORATION).

### Production Example 1

### [Preparation of carbodiimide compound]

### (Carbodiimide compound A)

Into a four necked flask equipped with a reflux condenser tube, a nitrogen inlet tube, a stirring rod and a thermometer, 76 parts by mass of a polycarbodiimide compound with a carbodiimide equivalent of 316 having an isocyanate group and 203.2 parts by mass of polymethylmethacrylate diol having a molecular weight of 1000 were charged, and the mixture was maintained at about 100°C for 5 hours to react an isocyanate group with a hydroxyl group, and then into this, 246.3 parts by mass of polycaprolactone with a molecular weight of 2000 having a carboxyl group and 788.3 parts by mass of propylene glycol monomethyl ether acetate were charged, and the mixture was maintained at about 80°C for 2 hours to react a carbodiimide group with a carboxyl group to obtain a carbodiimide compound A having a solid matter content of 40% by mass.

### Production Example 2

### (Carbodiimide compound B)

Into a four necked flask equipped with a reflux condenser tube, a nitrogen inlet tube, a stirring rod and a thermometer, 76 parts by mass of a polycarbodiimide compound with a carbodiimide equivalent of 316 having an isocyanate group and 22.2 parts by mass of N-methyldiethanolamine were charged, and the mixture was maintained at about 100°C for 2 hours to react an isocyanate group with a hydroxyl group, and then into this, 246.3 parts by mass of polycaprolactone with a molecular weight of 2000 having a carboxyl group and 516.8 parts by mass of propylene glycol monomethyl ether acetate were charged, and the mixture was maintained at about 80°C for 2 hours to react a carbodiimide group with a carboxyl group to obtain a carbodiimide compound B having a solid matter content of 40% by mass.

### Production Example 3

### (Carbodiimide compound C)

Into a four necked flask equipped with a reflux condenser tube, a nitrogen inlet tube, a stirring rod and a thermometer, 76 parts by mass of a polycarbodiimide compound with a carbodiimide equivalent-of 316 having an isocyanate group and 203.2 parts by mass of polymethyl methacrylate diol having a molecular weight of 1000 were charged, and the mixture was maintained at about 100°C for 5 hours to react an isocyanate group with a hydroxyl group, and then into this, 492.6 parts by mass of polycaprolactone with a molecular weight of 2000 having a carboxyl group and 1157.7 parts by mass of propylene glycol monomethyl ether acetate were charged, and the mixture was maintained at about 80°C for 2 hours to react a carbodiimide group with a carboxyl group to obtain a carbodiimide compound C having a solid matter content of 40% by mass.

### Production Example 4

### (Carbodiimide compound D)

Into a four necked flask equipped with a reflux condenser tube, a nitrogen inlet tube, a stirring rod and a thermometer, 76 parts by mass of a polycarbodiimide compound with a carbodiimide equivalent of 316 having an isocyanate group and 22.2 parts by mass of N-methyldiethanolamine were charged, and the mixture was maintained at about 100°C for 2 hours to react an isocyanate group with a hydroxyl group, and then into this, 492 . 6 parts by mass of polycaprolactone with a molecular weight of 2000 having a carboxyl group and 886.2 parts by mass of propylene glycol monomethyl ether acetate were charged, and the mixture was maintained at about 80°C for 2 hours to react a carbodiimide group with a carboxyl group to obtain a carbodiimide compound D having a solid matter content of 40% by mass.

### Production Example 5

### [Acid radical-containing resin 1]

A 40% by mass solution of propylene glycol monomethyl ether acetate, which is a benzyl methacrylate-methacrylic acid copolymer having a weight average molecular weight of 10000 and an acid value of 100 mgKOH/g, was used as an acid radical-containing resin 1.

### Production Example 6

### [Acid radical-containing resin 2]

A 40% by mass solution of propylene glycol monomethyl ether acetate, which is a benzyl methacrylate-methacrylic acid copolymer having a weight average molecular weight of 16000 and an acid value of 60 mgKOH/g, was used as an acid radical-containing resin 2.

### [Preparation of acid radical-containing carbodiimide compound]

### Production Example 7

### (Acid radical-containing carbodiimide compound A)

Into a four necked flask equipped with a reflux condenser tube, a nitrogen inlet tube, a stirring rod and a thermometer, 1313.8 parts by mass of a carbodiimide compound A (solid matter content 40% by mass) and 598.2 parts by mass of an acid radical-containing resin 1 (solid matter content 40% by mass) were charged, and the mixture was maintained at about 80°C for 2 hours to react a carbodiimide group with a carboxyl group to obtain an acid radical-containing carbodiimide compound A having a solid matter content of 40% by mass. This compound had a peak at a position of a wavelength of 1700 cm⁻¹ of infrared rays and was proved to have an acid radical.

### Production Example 8

### (Acid radical-containing carbodiimide compound B)

Into a four necked flask equipped with a reflux condenser tube, a nitrogen inlet tube, a stirring rod and a thermometer, 861.3 parts by mass of a carbodiimide compound B (solid matter content 40% by mass) and 598.2 parts by mass of an acid radical-containing resin 1 (solid matter content 40% by mass) were charged, and the mixture was maintained at about 80°C for 2 hours to react a carbodiimide group with a carboxyl group to obtain an acid radical-containing carbodiimide compound B having a solid matter content of 40% by mass. This compound had a peak at a position of a wavelength of 1700 cm⁻¹ of infrared rays and was proved to have an acid radical.

### Production Example 9

### (Acid radical-containing carbodiimide compound C)

Into a four necked flask equipped with a reflux condenser tube, a nitrogen inlet tube, a stirring rod and a thermometer, 861.3 parts by mass of a carbodiimide compound B (solid matter content 40% by mass) and 750.0 parts by mass of an acid radical-containing resin 2 (solid matter content 40% by mass) were charged, and the mixture was maintained at about 80°C for 2 hours to react a carbodiimide group with a carboxyl group to obtain an acid radical-containing carbodiimide compound C having a solid matter content of 40% by mass. This compound had a peak at a position of a wavelength of 1700 cm⁻¹ of infrared rays and was proved to have an acid radical.

### Examples 1 to 7 and Comparative Examples 1 to 4

### [Pigment dispersion composition]

Materials having the composition shown in Table 1 were kneaded with a bead mill at 60°C for one day to obtain pigment dispersion compositions. However, as for the composition of the acid radical-containing carbodiimide compounds A, B and C, the acid radical-containing resins, the carbodiimide compounds B, C and D and the pigment dispersant in Table 1, values of solid matter alone are shown.

### [Pigment dispersion resist composition]

Using a high speed mixer, the pigment dispersion compositions of Examples 1 to 7 and Comparative Examples 1 to 4 and other materials were mixed uniformly so as to become the composition shown in Table 1, and each of the resulting mixtures was filtrated with a filter of 3 µm in pore diameter to obtain a pigment dispersion resist composition.

### [Evaluation test]

### (Dispersion stability)

The pigment dispersion compositions of Examples 1 to 7 and Comparative Examples 1 to 4 and the pigment dispersion resist compositions of Examples 1 to 7 and Comparative Examples 1 to 4 were sampled and put into a glass bottle and the bottle was closed with a stopper to be left standing at room temperature for 7 days. After this, a state thereof was evaluated according to the following criteria. The results of evaluations are shown in Table 1.
Evaluation criteria
A: there is no thickening and precipitations
B: there is thickening and precipitations to the extent to which they are turned back in shaking the bottle lightly
C: there is thickening and precipitations to the extent to which thickening and precipitations are not turned back even in shaking the bottle strongly

### (Development property of resist pattern)

The pigment dispersion resist compositions of Examples 1 to 7 and Comparative Examples 1 to 4 was applied onto a glass substrate so as to have a film thickness of 1 µm with a spin coater and prebaked at 100°C for 3 minutes. The obtained coat was developed with an aqueous solution of KOH of a pH 12 and a development property was ranked based on a time period after which a resist composition of an uncured portion can be thoroughly removed according to the following time criteria. The results are shown in Table 1.
Evaluation criteria
A: a resist composition can be thoroughly removed within 30 second
B: a resist composition can be thoroughly removed after time period of more than 30 seconds and 60 seconds or less
C: a resist composition cannot be thoroughly removed after time period of more than 60 seconds

### (Development behavior of resist pattern)

The pigment dispersion resist compositions of Examples 1 to 7 and Comparative Examples 1 to 4 was applied onto a glass substrate so as to have a film thickness of 1 µm with a spin coater and prebaked at 100°C for 3 minutes. The obtained coat was developed with an aqueous solution of KOH of a pH 12 and the development behavior in thoroughly removing a resist composition of an uncured portion was visually evaluated. The results are shown in Table 1.

**Table 1**

| | Example | | | | | | | Comparative Example | | | |
|---|---|---|---|---|---|---|---|---|---|---|---|
| | 1 | 2 | 3 | 4 | 5 | 6 | 7 | 1 | 2 | 3 | 4 |
| | Carbon type | | | | | Organic pigment type | | Carbon type | | | Organic pigment type |
| | Reaction system | Reaction system | Reaction system | Mixture system | Mixture system | Reaction system | Mixture system | Reaction system | Reaction system | Commercial dispersant | |
| Pigment dispersion composition | | | | | | | | | | | |
| Carbon black (average particle diameter 56 nm.pH=3.1) | 20.0 | 20.0 | 20.0 | 20.0 | 20.0 | - | - | 20.0 | 20.0 | 20.0 | - |
| Pigment Green 36 | - | - | - | - | - | 16.0 | 16.0 | - | - | - | 16.0 |
| Acid radical-containing carbodiimide compound B (without carbodiimide group/with basic nitrogen-containing chain) | 8.0 | - | - | - | - | 9.6 | - | - | - | - | - |
| Acid radical-containing carbodiimide compound A (without carbodiimide group/without basic nitrogen-containing chain) | - | 8.0 | - | - | - | - | - | - | - | - | - |
| Acid radical-containing carbodiimide compound C (without carbodiimide group/without basic nitrogen-containing chain) | - | - | 10.0 10. | - | - | - | - | - | - | - | - |
| Acid radical-containing resin 1 | - | - | - | 4.0 | - | - | 4.8 | - | - | - | - |
| Acid radical-containing resin 2 | - | - | - | | 5.0 | - | - | - | - | - | - |
| Carbodiimide compounds B (with carbodiimide group/with basic nitrogen-containing chain) | - | - | - | 4.0 | 5.0 | - | 4.8 | - | - | - | 4.8 |
| Carbodiimide compound D (without carbodiimide group/with basic nitrogen-containing chain) | - | - | - | - | - | - | - | 8.0 | - | - | - |
| Carbodiimide compound C (without carbodiimide group/without basic nitrogen-containing chain) | - | - | - | - | - | - | - | - | 8.0 | - | - |
| Pigment dispersant (Disperbyk-161) | - | - | - | - | - | - | - | - | - | 8.0 | - |
| Pigment dispersant(PB-821) | - | - | - | - | - | - | - | - | - | - | 4.8 |
| Solvent (PGMEA) | 72.0 | 72.0 | 70.0 | 72.0 | 70.0 | 74.4 | 74.4 | 72.0 | 72.0 | 72.0 | 74.4 |
| Total | 100.0 | 100.0 | 100.0 | 100.0 | 100.0 | 100.0 | 100.0 | 100.0 | 100.0 | 100.0 | 100.0 |
| Dispersion stability | A | A | A | A | A | A | A | A | B | B | B |
| Pigment dispersion resist composition | | | | | | | | | | | |
| The above pigment dispersion composition | 40.0 | 40.0 | 40.0 | 40.0 | 40.0 | 43.8 | 43.8 | 40.0 | 40.0 | 40.0 | 43.8 |
| BzMA/MAA copolymer DPEHA | 5.6 | 5.6 | 5.6 | 5,6 | 5.6 | 4.8 | 4.8 | 5.6 | 5.6 | 5.6 | 4.8 |
| | 2.4 | 2.4 | 2.4 | 2.4 | 2.4 | 3.0 | 3.0 | 2.4 | 2.4 | 2.4 | 3.0 |
| Irgacure 907 | 0.8 | 0.8 | 0.8 | 0.8 | 0.8 | 1.0 | 1.0 | 0.8 | 0.8 | 0.8 | 1.0 |
| PGMEA | 51.2 | 51.2 | 51.2 | 51.2 | 51.2 | 47.4 | 47.4 | 51.2 | 51.2 | 51.2 | 47.4 |
| Total | 100.0 | 100,0 | 100.0 | 100.0 | 100.0 | 100.0 | 100.0 | 100.0 | 100.0 | 100.0 | 100.0 |
| Dispersion stability | A | A | A | A | A | A | A | A | C | B | B |
| Development property | A | A | A | A | A | A | A | A | C | B | B-C |
| Developing condition | dissolved | dissolved | dissolved | dissolved | dissolved | dissolved | dissolved | peeled off | peeled off | peeled off | dissolved |
| (unit: % by mass) | | | | | | | | | | | |

Incidentally, trade names and abbreviations shown in Table 1 are as follows.
Disperbyk-161 (trade name, pigment dispersant produced by BYK-Chemie)
PB-821 (trade name, pigment dispersant produced by Ajinomoto Co., Inc.)
PGMEA (propylene glycol monomethyl ether acetate (PMAC))
BzMA-MAA copolymer (benzyl methacrylate-methacrylic acid copolymer)
DPEHA (dipentaerythritol hexaacrylate)
Irgacure 907 (trade name, 2-methyl-1[4-(methylthio)phenyl]-2-morpholinopropane-1-on produced by Ciba Specialty Chemicals K.K.)

### INDUSTRIAL APPLICABILITY

A pigment dispersion composition of the present invention has good fluidity and dispersion stability even in the case of having a high pigment concentration. The pigment dispersion composition of the present invention exhibits excellent development characteristics particularly when it is used for the areas requiring development characteristics such as a resist composition for a color filter or a resist composition for a black matrix.

## Claims

1. A pigment dispersion composition formed by dispersing a pigment in a dispersion medium,
wherein the surface of said pigment is coated with an acid radical-containing reactant produced by the reaction of a carbodiimide compound having at least one carbodiimide group with an acid radical-containing resin having an acid value of 20 to 300 mgKOH/g and a weight average molecular weight of 1000 to 100000.

2. The pigment dispersion composition according to claim 1,
wherein said carbodiimide compound has at least one kind of a side chain selected from the group consisting of a polyester side chain, a polyether side chain and a polyacrylic side chain in a molecule.

3. The pigment dispersion composition according to claim 1 or 2,
wherein said carbodiimide compound is a carbodiimide compound with a carbodiimide equivalent of 100 to 50000.

4. The pigment dispersion composition according to any one of claims 1 to 3, wherein an acid radical of said acid radical-containing resin is a carboxyl group, a sulfonic acid group or a phosphoric acid group.

5. The pigment dispersion composition according to any one of claims 1 to 4,
wherein said acid radical-containing resin is an acid radical-containing copolymer resin obtained by radically polymerizing a monomer component containing at least one kind of monomers having an acid radical.

6. A method of producing the pigment dispersion composition according to any one of claims 1 to 5,
comprising the steps of: coating the surface of a pigment using an acid radical-containing reactant obtained by reacting a carbodiimide compound having at least one carbodiimide group with an acid radical-containing resin having an acid value of 20 to 300 mgKOH/g and a weight average molecular weight of 1000 to 100000 in advance; and dispersing the coated pigment in a dispersion medium.

7. A method of producing the pigment dispersion composition according to any one of claims 1 to 5,
comprising the steps of: coating the surface of a pigment by pre-treating the surface of a pigment with a carbodiimide compound having at least one carbodiimide group and then reacting a residual carbodiimide group in the carbodiimide compound with an acid radical-containing resin having an acid value of 20 to 300 mgKOH/g and a weight average molecular weight of 1000 to 100000; and dispersing the coated pigment in a dispersion medium.

8. A method of producing the pigment dispersion composition according to any one of claims 1 to 5,
comprising the steps of: coating the surface of a pigment by conducting a reaction in a mixture containing at least a pigment, a carbodiimide compound having at least one carbodiimide group, and an acid radical-containing resin having an acid value of 20 to 300 mgKOH/g and a weight average molecular weight of 1000 to 100000; and dispersing the coated pigment in a dispersion medium.

9. The method of producing the pigment dispersion composition according to any one of claims 6 to 8,
wherein the step of coating the surface of a pigment and the step of dispersing the pigment in a dispersion medium are simultaneously performed.

10. A pigment dispersion resist composition containing the pigment dispersion composition according to any one of claims 1 to 5.

11. A compound for pigment treatment, wherein said compound for pigment treatment is obtained by reacting a carbodiimide compound having at least one carbodiimide group with an acid radical-containing resin having an acid value of 20 to 300 mgKOH/g and a weight average molecular weight of 1000 to 100000 and further has an acid radical in a molecule.
